# FASCICULE DE BREVET EUROPEEN

(11) **EP 2 107 382 B1**
(45) Date de publication et mention de la délivrance du brevet: **31.10.2018**
(21) Numéro de dépôt: 09155771.0
(22) Date de dépôt: 20.03.2009
(51) Int. Cl.: G01R 19/165, H02J 13/00, G01R 31/28, H01H 9/16

(54) **Détection de l'état des éléments d'une branche électrique comprenant une charge et un interrupteur**
Zustandserkennung der Elemente eines Zweigs einer Stromleitung, die eine Last und einen Schalter umfasst
Detection of the status of the elements of an electric branch comprising a load and a switch

(30) Priorité: 31.03.2008 FR 0852085
(43) Date de publication de la demande: 07.10.2009
(73) Titulaire: STMicroelectronics (Tours) SAS, 37100 Tours (FR)
(72) Inventeur: Benabdelaziz, Ghafour, 37000 TOURS (FR); Paillet, Pascal, 37540 SAINT CYR SUR LOIRE (FR)
(74) Mandataire: Cabinet Beaumont

(56) Documents cités:
- EP-A1- 0 843 400
- EP-A2- 1 885 059
- US-A1- 2006 043 944
- US-B2- 6 710 580

## Description

### Domaine de l'invention

La présente invention concerne, de façon générale, la détection de l'état d'une charge alimentée par une alimentation alternative et, plus particulièrement, la surveillance de l'état de cette charge et d'un ou plusieurs commutateurs qui la commandent.

La présente invention s'applique plus particulièrement à la détection d'éventuelles défaillances de la charge et du ou des commutateurs en série avec cette charge.

### Exposé de l'art antérieur

De nombreux circuits et procédés de détection de la défaillance d'une charge ont été proposés. Par exemple, la demande de brevet US N° 2006/0043944 prévoit d'étudier l'allure de la tension aux bornes de la charge et de la comparer à des seuils. Ce circuit ne permet cependant pas de distinguer tous les états possibles des composants du circuit (charge et commutateurs). Voir aussi le document EP0843400.

### Résumé de l'invention

L'invention vise à pallier tout ou partie des inconvénients des techniques connues.

Un mode de réalisation vise à permettre la détection de tous les états possibles des éléments d'un circuit série d'alimentation d'une charge.

Un mode de réalisation vise une solution alternative à une mesure de la tension aux bornes de la charge.

Un mode de réalisation vise à permettre la détection de tous les états possibles des éléments d'un circuit d'alimentation de plusieurs charges en série ou en parallèle.

Pour atteindre tout ou partie de ces objets, l'invention fournit un procédé de détection de l'état d'au moins un élément d'un circuit comprenant une ou plusieurs charges, alimentées par une tension alternative et en série avec au moins un premier commutateur, l'état de l'élément étant obtenu en analysant, à plusieurs instants par période de la tension alternative, l'amplitude d'un courant prélevé au point d'interconnexion entre la charge et le premier commutateur.

Selon un mode de réalisation, un premier instant correspond au maximum de la tension alternative, un deuxième instant correspond au minimum de la tension alternative, un troisième instant est compris entre le premier instant et la fin de l'alternance positive de la tension alternative, et un quatrième instant est compris entre le deuxième instant et la fin de l'alternance négative de la tension alternative. L'analyse consiste à comparer, à chaque instant, l'amplitude du courant à au moins un seuil de courant, à former un mot d'états logiques à partir du résultat des comparaisons et à comparer ce mot d'états logiques à des mots stockés dans une table.

Selon un mode de réalisation, un premier seuil de courant est défini lors de l'alternance positive de la tension alternative et un second seuil de courant est défini lors de l'alternance négative de la tension alternative.

Selon un mode de réalisation, le procédé permet en outre de déterminer l'état d'un deuxième commutateur placé en série avec le premier commutateur et la charge en analysant, à au moins huit instants par période de la tension alternative, l'amplitude du courant prélevé au point d'interconnexion entre la charge et le premier commutateur.

Selon un mode de réalisation, le procédé permet en outre de déterminer l'état d'au moins un élément d'au moins une seconde branche, parallèle à une première branche comprenant en série au moins la charge et au moins le premier commutateur, la seconde branche comprenant au moins une seconde charge et au moins un troisième commutateur, en analysant, à plusieurs instants par période de la tension alternative, l'amplitude d'un courant égal à la somme du courant prélevé au point d'interconnexion entre la première charge et le premier commutateur et d'un courant prélevé au point d'interconnexion entre la seconde charge et le troisième commutateur.

L'invention fournit également un circuit de détection de l'état d'au moins un élément d'un circuit comprenant une ou plusieurs charges alimentées par une tension alternative en série avec au moins un premier commutateur, le circuit comprenant un moyen d'analyse de l'amplitude d'un courant, prélevé au point d'interconnexion entre la charge et le premier commutateur, à plusieurs instants par période de la tension alternative.

Selon un mode de réalisation, le circuit comprend en outre au moins un deuxième commutateur en série avec la charge et le premier commutateur dont l'état peut être déterminé par le moyen d'analyse de l'amplitude du courant prélevé au point d'interconnexion entre la charge et le premier commutateur, à au moins huit instants par période de la tension alternative.

Selon un mode de réalisation, le circuit comprend une seconde branche en parallèle d'une première branche comprenant au moins la charge et au moins le premier commutateur, la seconde branche comprenant au moins une seconde charge et un troisième commutateur dont les états peuvent être déterminés par le moyen d'analyse de l'amplitude d'un courant égal à la somme du courant prélevé au point d'interconnexion entre la première charge et le premier commutateur et d'un courant prélevé au point d'interconnexion entre la seconde charge et le troisième commutateur.

### Brève description des dessins

Ces objets, caractéristiques et avantages, ainsi que d'autres seront exposés en détail dans la description suivante des modes de réalisation particuliers faite à titre non-limitatif en relation avec les figures jointes parmi lesquelles :
la figure 1 illustre un circuit de surveillance de l'état d'une charge selon un mode de réalisation ;
les figures 2 et 3 illustrent le fonctionnement d'un comparateur à fenêtre pouvant être intégré au circuit de la figure 1 ;
la figure 4 illustre un exemple de circuit comparateur à fenêtre du type décrit en figures 2 et 3 ;
les figures 5A et 5B sont des chronogrammes illustrant un premier exemple d'allure du courant en entrée du comparateur à fenêtre de la figure 1 et du signal correspondant en sortie ;
les figures 6A et 6B sont des chronogrammes illustrant un deuxième exemple d'allure du courant en entrée du comparateur à fenêtre de la figure 1 et du signal correspondant en sortie ;
les figures 7A et 7B sont des chronogrammes illustrant un troisième exemple d'allure du courant en entrée du comparateur à fenêtre de la figure 1 et du signal correspondant en sortie ;
la figure 8 est un organigramme illustrant un procédé de surveillance de l'état d'une charge selon un mode de réalisation ;
la figure 9 est un schéma-bloc d'un mode de réalisation d'un système exploitant le signal fourni par le circuit de la figure 1 ;
les figures 10A à 10G sont des chronogrammes illustrant un procédé de surveillance de l'état d'une charge selon un autre mode de réalisation ; et
la figure 11 illustre un circuit de surveillance de l'état de deux charges en parallèle selon un autre mode de réalisation.

De mêmes éléments ont été désignés par de mêmes références aux différentes figures.

### Description détaillée

Pour des raisons de clarté, seules les étapes et éléments utiles à la compréhension de l'invention ont été représentés et seront décrits. En particulier, la nature de la ou des charges présentes dans le circuit ne sera pas détaillée, tout type de charge pouvant être surveillé par le circuit de l'invention pourvu que, si un élément de protection est placé en parallèle avec la charge, la charge ait une impédance faible par rapport à cet élément de protection.

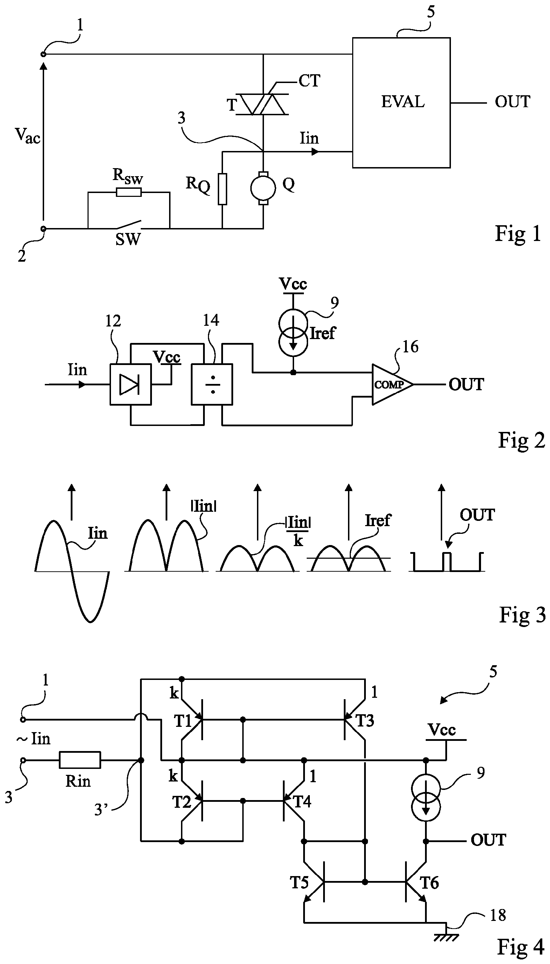

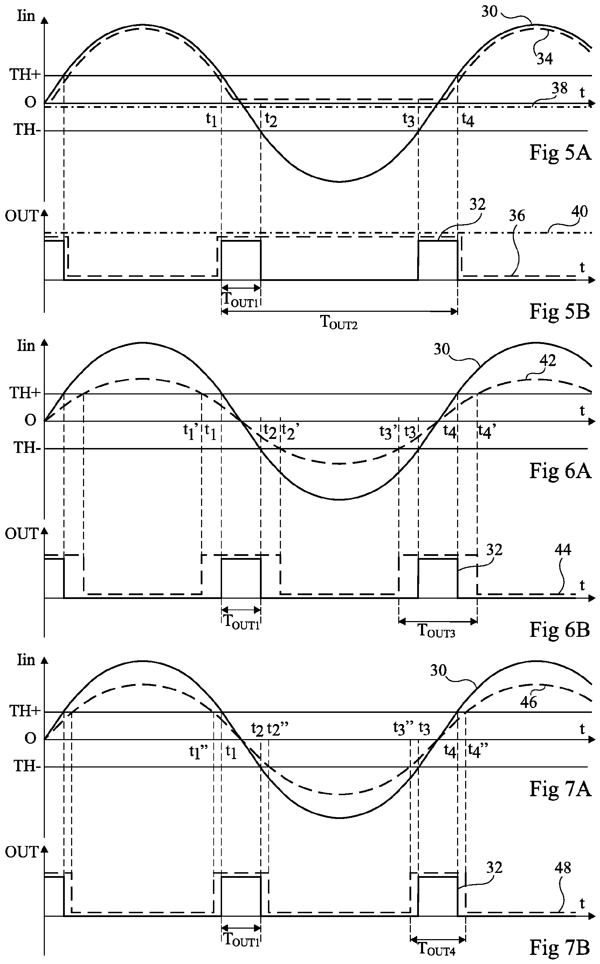

La figure 1 illustre un circuit de détection de l'état d'une charge et de deux commutateurs qui la commandent selon un mode de réalisation. Ce circuit comprend une charge Q en série avec deux commutateurs T et SW entre deux bornes d'application 1 et 2 d'une tension alternative Vac. Le commutateur T est, par exemple, un triac commandé par un signal de commande CT d'un programmateur (non représenté), par exemple celui d'une machine à laver. Dans le cas d'une machine à laver, le commutateur SW peut symboliser un contact de détection d'ouverture de la porte de la machine de façon à interrompre l'alimentation du moteur en cas d'ouverture de la porte (ouverture du second commutateur). Une résistance R_{Q}, de valeur supérieure à l'impédance de la charge Q, est en parallèle avec la charge. Une résistance R_{SW} de forte valeur est en parallèle avec le commutateur SW, la résistance R_{SW} étant inférieure à la résistance R_{Q}. Un comparateur à fenêtre 5 (EVAL) est placé entre les bornes 1 et 3 du triac T. Il évalue un courant Iin prélevé au point d'interconnexion entre la charge Q et le triac T et fournit une sortie OUT qui est, par exemple, à un niveau haut lorsque le courant Iin est situé dans une fenêtre de courants et à un niveau bas autrement. Le fonctionnement détaillé du circuit de la figure 1 sera décrit ci-après en relation avec les figures 5A, 5B, 6A, 6B, 7A et 7B.

La figure 2 est un schéma-bloc illustrant le fonctionnement d'un comparateur à fenêtre 5 pouvant être utilisé dans le circuit de la figure 1.

La figure 3 illustre le fonctionnement du comparateur à fenêtre de la figure 2 en représentant des exemples d'allures de signaux caractéristiques.

Le comparateur à fenêtre 5 compare le courant alternatif d'entrée Iin à une fenêtre de courants autour du zéro de courant définie par un seuil de courant Iref (source de courant 9). Le courant Iin est d'abord redressé (bloc 12). Ce redressement double alternance est effectué par rapport à une tension continue Vcc, ce qui évite la présence d'une tension négative en aval. Puis, le courant redressé |Iin| est divisé par une valeur k (bloc 14). Le résultat (|Iin|/k) est comparé (bloc 16, COMP) au courant de référence continu et constant Iref. Si le courant mesuré est supérieur au courant Iref, la sortie OUT de la fonction de comparaison est au niveau bas. Sinon, la sortie OUT est à un niveau non nul.

La figure 4 illustre un exemple de réalisation du circuit comparateur à fenêtre 5 de la figure 2, placé entre deux bornes d'entrée 1 et 3. Deux transistors bipolaires PNP T1 et T2 sont chacun connectés entre une borne 3' et la borne 1 correspondant à la borne d'application d'une tension continue Vcc. La borne 3' est reliée à la borne d'entrée 3 par l'intermédiaire d'une résistance Rin de conversion tension-courant. La résistance Rin est de forte valeur et a pour rôle d'assurer la tenue en tension du comparateur 5 par rapport à la tension alternative d'entrée. L'émetteur du transistor T1 est relié à la borne 3' tandis que l'émetteur du transistor T2 est relié à la borne 1. Le transistor T1 est monté en diode et en miroir de courant sur un transistor PNP T3 dont l'émetteur est relié à la borne 3'. Le transistor T2 est monté en diode et en miroir de courant sur un transistor PNP T4 dont l'émetteur est relié à la borne 1 et dont le collecteur est relié au collecteur du transistor T3. Les bases des transistors T1 et T3 sont reliées au collecteur du transistor T1 (borne 1). Les bases des transistors T2 et T4 sont reliées au collecteur du transistor T2. Les transistors T1 et T2 assurent la fonction de redressement double alternance (12, figure 2). Le miroir de courant des transistors T1 et T3 (respectivement T2 et T4) assure la fonction de diviseur de courant 14 de rapport k, k étant fixé par le rapport entre les surfaces d'émetteur des transistors (k pour les transistors T1 et T2, 1 pour les transistors T3 et T4). Un miroir de courant formé de deux transistors T5 et T6 de type NPN est chargé de prélever, de la source 9, un courant proportionnel à celui du collecteur du transistor T3 ou T4, selon l'alternance du courant Iin. Le transistor T5 a son collecteur relié à sa base et aux collecteurs des transistors T3 et T4 et son émetteur relié à la masse 18. Le transistor T6 a son émetteur relié à la masse et a son collecteur relié à la source de courant 9 en définissant la borne de sortie OUT. Les bases des transistors T5 et T6 sont reliées ensemble aux collecteurs des transistors T3, T4 et T5. Le transistor T6 en miroir sur le transistor T5 réalise la soustraction du courant dans le transistor T3 ou T4 par le courant constant Iref de la source 9, ce qui constitue la fonction de comparaison 16. Lorsque le courant mesuré est supérieur au courant Iref, la sortie OUT est au niveau bas (tout le courant Iref est absorbé par le transistor T6). Autrement, la source de courant 9 assure un niveau non nul sur la sortie OUT.

La source de courant 9 est réalisée par exemple au moyen d'une résistance, d'un montage de transistors connu sous le nom de source de Widlar ou de toute autre source de courant intégrée. La valeur du courant Iref sera choisie de façon adaptée en fonction des seuils de courant désirés.

Le comparateur à fenêtre 5 de la figure 1 pourra être tout autre comparateur à fenêtre connu fonctionnant selon le schéma de la figure 2 ou de façon similaire à celui-ci.

Les figures 5A, 5B, 6A, 6B, 7A et 7B illustrent le fonctionnement du circuit de la figure 1. Les figures 5A et 5B illustrent, respectivement, l'allure du courant Iin et de la sortie OUT en fonction des différents états possibles du triac T. Les figures 6A et 6B représentent des allures de ces mêmes signaux en fonction des différents états possibles de la charge Q en considérant que le triac T est ouvert, et les figures 7A et 7B en fonction des différents états possibles du commutateur SW en considérant que le triac T est ouvert. Dans les chronogrammes représentant l'allure du courant Iin, des seuils TH- et TH+ sont représentés symétriquement par rapport au zéro de courant. Si le comparateur à fenêtre de la figure 1 est celui des figures 2 et 3, ces seuils sont égaux à kxIref. Les valeurs des seuils TH+ et TH- seront choisies en faisant un compromis entre des valeurs faibles qui assurent la détection de tous les états possibles du circuit de la figure 1 et des valeurs élevées qui permettent une bonne détectabilité de ces différents états. Les seuils TH- et TH+ peuvent avoir des valeurs différentes. Pour simplifier, on suppose une charge Q purement résistive.

Les figures 5A et 5B illustrent la variation du courant Iin et de la sortie OUT en fonction de l'état du triac T, en considérant que la charge Q fonctionne correctement et que le commutateur SW est fermé. Dans le cas où le triac T est ouvert sur toutes les alternances, le courant Iin est un courant alternatif proportionnel à la tension d'alimentation Vac (courbe 30 en traits pleins en figure 5A). La sortie OUT correspondante est illustrée en figure 5B par une courbe 32 en traits pleins. A un instant t₁, le courant Iin passe en dessous du seuil TH+, ce qui provoque le passage à l'état haut de la sortie OUT. A un instant t₂ postérieur, le courant Iin passe en dessous du seuil TH-, ce qui provoque le passage à l'état bas de la sortie OUT. Le même motif se produit sur la sortie OUT lors de l'alternance suivante, entre des instants t₃ et t₄.

Dans le cas où le triac T est ouvert sur l'une des alternances et est fermé sur l'autre alternance (mode diode), le courant Iin a l'allure de la courbe en pointillés 34 et la sortie OUT l'allure de la courbe en pointillés 36. Lors de la première alternance, la courbe 34 suit la courbe 30 et la courbe 36 suit la courbe 32. Ensuite, entre les instants t₂ et t₄, la courbe 34 reste à zéro et la sortie OUT est à l'état haut. Dans le cas où le triac T est fermé sur les deux alternances, le courant Iin est nul, comme cela est illustré en figure 5A par une courbe en traits mixtes 38 et la sortie OUT reste à l'état haut, comme cela est illustré par la courbe en traits mixtes 40.

On appellera T_{OUT} la durée pendant laquelle la sortie OUT est à l'état haut sur une alternance. Lorsque le triac T est ouvert, on a T_{OUT} = T_{OUT1} = t₂-t₁. Lorsque le triac T est en mode diode, on a T_{OUT} = T_{OUT2} = t₄-t₁ > T_{0UT1}. Il est donc possible de déterminer l'état du triac T en fonction de la durée T_{OUT}. La comparaison de l'état courant du triac T par rapport au signal de commande CT qui lui est appliqué permet d'en déterminer une éventuelle défaillance.

Les figures 6A et 6B illustrent les variations du courant Iin et de la sortie OUT en fonction des états de la charge Q en considérant que le triac T est ouvert et que le commutateur SW est fermé. Dans le cas où la charge Q fonctionne correctement, c'est-à-dire qu'elle est connectée et qu'elle a une impédance faible, le courant Iin suit la courbe 30 et la sortie OUT la courbe 32 (traits pleins) identiques à celles des figures 5A et 5B.

Dans le cas où la charge Q est défaillante, c'est-à-dire que son impédance augmente ou qu'elle est déconnectée (la résistance R_{Q}, de forte valeur, fait alors la jonction entre les bornes 2 et 3), le courant Iin suit une courbe en pointillés 42 et la sortie OUT correspondante une courbe en pointillés 44. L'augmentation de l'impédance entre les bornes 2 et 3 (due à la défaillance de la charge ou à sa déconnexion) entraîne une diminution du courant Iin. De ce fait, la courbe du courant Iin coupe les seuils TH+ et TH- à des instants t₁', t₂', t₃' et t₄' différents des instants t₁, t₂, t₃ et t₄. On obtient ainsi une durée T_{OUT3} = t₄'-t₃' supérieure à la durée T_{OUT1}. La valeur de la durée T_{OUT} permet donc de déterminer l'état de la charge Q.

Les figures 7A et 7B illustrent les variations de la sortie OUT en fonction des états du commutateur SW en considérant que le triac T est ouvert et la charge Q fonctionne correctement.

Dans le cas où le commutateur SW est fermé, on retrouve les courbes 30 et 32 en traits pleins identiques à celles des figures 5A et 5B. Dans le cas où le commutateur SW est ouvert, la résistance R_{SW} assure la jonction entre la borne 2 et la charge Q. Le courant Iin suit alors une courbe en pointillés 46 proportionnelle à la courbe 30 et la sortie OUT suit une courbe en pointillés 48. Le courant Iin coupe les seuils TH+ et TH- à des instants t₁", t₂", t₃" et t₄" différents des instants t₁, t₂, t₃ et t₄. De plus, la résistance R_{SW} étant différente de la résistance R_{Q}, les instants t₁", t₂", t₃" et t₄" sont également différents des instants t₁', t₂', t₃' et t₄'. Dans le cas où la résistance R_{SW} est inférieure à la résistance R_{Q}, on obtient une durée T_{QUT4} supérieure à la durée T_{OUT1} et inférieure à la durée T_{QUT3}.

Un mode de réalisation prévoit de combiner les propriétés précédemment décrites pour obtenir l'état de la charge et des commutateurs en série avec la charge. Pour cela, on définit, de façon adaptée, des seuils de durée TH1, TH2, TH3 et TH4 qui seront comparés à la durée T_{OUT}. On considère ici une durée T_{OUT} inférieure à la période de la tension d'alimentation Vac (triac non fermé sur deux alternances consécutives). On fixe le seuil TH1 inférieur au seuil TH2, le seuil TH3 inférieur au seuil TH1, et le seuil TH4 compris entre les seuils TH1 et TH2. Les seuils TH1 et TH2 permettent de caractériser l'état de la charge Q et du triac T. Lorsque la durée T_{OUT} est inférieure au seuil TH1, le triac T est ouvert et la charge Q fonctionne correctement. Lorsque la durée T_{OUT} est comprise entre les seuils TH1 et TH2, le triac T est ouvert et la charge Q est défaillante ou déconnectée. Lorsque la durée T_{OUT} est supérieure à TH2, le triac est en mode diode. Les seuils TH3 et TH4 permettent de caractériser l'état du commutateur SW. Lorsque la durée T_{OUT} est inférieure au seuil TH3 ou lorsqu'elle est comprise entre les seuils TH1 et TH4, le commutateur SW est fermé. Lorsque la durée T_{OUT} est comprise entre les seuils TH3 et TH1 ou TH4 et TH2, le commutateur SW est ouvert.

En variante, la résistance R_{SW} peut avoir une valeur supérieure à la résistance R_{Q}. Dans ce cas, on obtient une durée T_{OUT3} inférieure à la durée T_{OUT4}, et les seuils TH1, TH2, TH3 et TH4 seront adaptés en conséquence.

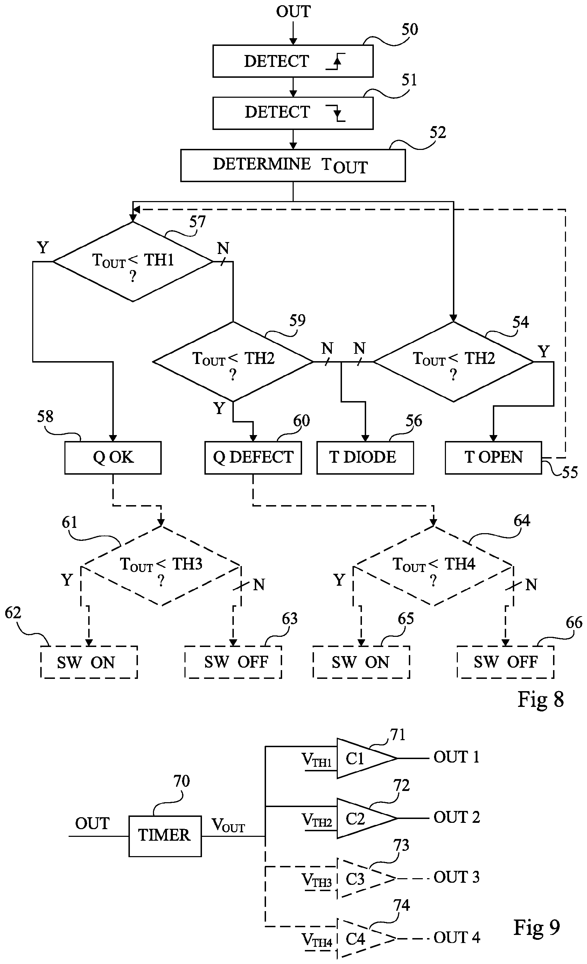

La figure 8 est un organigramme illustrant un procédé de surveillance de l'état d'une charge et d'au moins un commutateur en série avec la charge selon un mode de réalisation.

On commence par détecter un front montant sur la sortie OUT du comparateur 5 (bloc 50). Ensuite, on détecte un front descendant sur la sortie OUT (bloc 51). On détermine alors (bloc 52) la durée T_{OUT} pendant laquelle la sortie OUT a été à l'état haut.

On effectue ensuite différents tests en fonction de l'élément du circuit que l'on cherche à évaluer. Pour évaluer l'état du triac T, on effectue une comparaison (bloc 54) entre la durée T_{OUT} et le seuil TH2. Si la durée T_{OUT} est inférieure au seuil TH2 (bloc 55), cela signifie que le triac T est ouvert (T OPEN) et on peut alors tester les autres éléments du circuit. Dans le cas contraire (bloc 56), le triac est en mode diode (T DIODE).

Pour évaluer la charge Q, on compare la durée T_{OUT} au seuil TH1 (bloc 57). Si la durée T_{OUT} est inférieure au seuil TH1 (bloc 58), cela signifie que la charge Q est connectée et fonctionne correctement (Q OK). Dans le cas contraire, on compare la durée T_{OUT} au seuil TH2 (bloc 59). Si la durée T_{OUT} est inférieure au seuil TH2 (bloc 60), cela signifie que la charge Q est défaillante ou déconnectée (Q DEFECT) . Dans le cas contraire, le triac T est en mode diode (bloc 56).

A l'aide des comparaisons décrites ci-dessus, on peut déterminer l'état de la charge Q et du triac T. Dans le cas où un second commutateur SW est présent dans le circuit, on peut également déterminer l'état de ce commutateur. Les blocs nécessaires à cette évaluation optionnelle sont représentés en pointillés en figure 8.

Dans le cas où la charge Q fonctionne correctement (bloc 58), on compare la durée T_{OUT} au seuil TH3 (bloc 61). Si la durée T_{OUT} est inférieure au seuil TH3 (bloc 62), cela signifie que le commutateur SW est fermé (SW ON). Dans le cas contraire (bloc 63), le commutateur SW est ouvert (SW OFF).

Dans le cas où la charge Q est défaillante (bloc 60), on compare la durée T_{OUT} au seuil TH4 (bloc 64). Si la durée T_{OUT} est inférieure au seuil TH4 (bloc 65), cela signifie que le commutateur SW est fermé (SW ON). Dans le cas contraire (bloc 66), le commutateur SW est ouvert (SW OFF).

Le procédé décrit précédemment permet ainsi de déterminer l'état de tous les éléments constituant le circuit de la figure 1.

Les étapes de comparaison de la durée T_{OUT} aux seuils TH1, TH2, TH3 et TH4 peuvent être réalisées par divers moyens, par exemple à l'aide d'un microprocesseur. En variante, ces comparaisons peuvent être faites à l'aide d'un compteur temporel connecté sur la sortie OUT dont la sortie est incrémentée lorsque la sortie OUT est à l'état haut, et de moyens de comparaison du niveau de la sortie de ce comparateur temporel à des seuils.

La figure 9 représente un mode de réalisation d'un système exploitant le signal fourni par le circuit de la figure 1. La sortie OUT du circuit de la figure 1 est connectée à l'entrée d'un compteur 70 (TIMER) dont la sortie V_{OUT} est incrémentée lorsque la sortie OUT est à l'état haut. La sortie V_{OUT} est connectée à quatre comparateurs 71 à 74 (C1 à C4), la seconde entrée de ces comparateurs étant fixée à des seuils de tension V_{TH1}, V_{TH2}, V_{TH3} et V_{TH4} qui sont déterminés en fonction de la vitesse d'incrémentation du compteur pour correspondre aux seuils TH1, TH2, TH3 et TH4. L'état des sorties OUT1, OUT2, OUT3 et OUT4 des comparateurs 71 à 74 permet de déterminer l'état du circuit de la figure 1, en relation avec le procédé de la figure 8.

A titre d'exemple particulier de réalisation, l'application du procédé à un circuit où R_{Q} = 1,2 NΩ, R_{SW} = 620 kΩ, Rin = 200 kΩ et où la charge Q a une impédance de 300 Ω, dans le cas où le triac T est ouvert, donne des durées T_{OUT} égales à :
- 480 µs si Q fonctionne et que SW est fermé ;
- 2,02 ms si Q fonctionne et que SW est ouvert ;
- 3,46 ms si Q est défaillante et que SW est fermé ;
- 5,14 ms si Q est défaillante et que SW est ouvert.

Dans ce cas, les seuils TH1, TH2, TH3 et TH4 peuvent être respectivement fixés à 3 ms, 6 ms, 1 ms et 4 ms.

En pratique, si le triac T est commandé en ouverture par le signal de commande CT, on vérifie (étude du signal OUT) qu'il ne reste pas fermé ni en mode diode. Si le triac répond bien à la commande en ouverture, on étudie l'allure du signal OUT pour vérifier que la charge Q fonctionne correctement et que le commutateur SW est fermé.

Si le triac T est commandé en fermeture, on vérifie qu'il ne présente pas de défaillance en surveillant que le signal OUT est en permanence à l'état haut.

En pratique, la résistance Rin du circuit comparateur à fenêtre 5 de la figure 1 pourra être une résistance externe et les autres éléments du circuit 5, ainsi que le triac T, pourront être intégrés dans un même circuit.

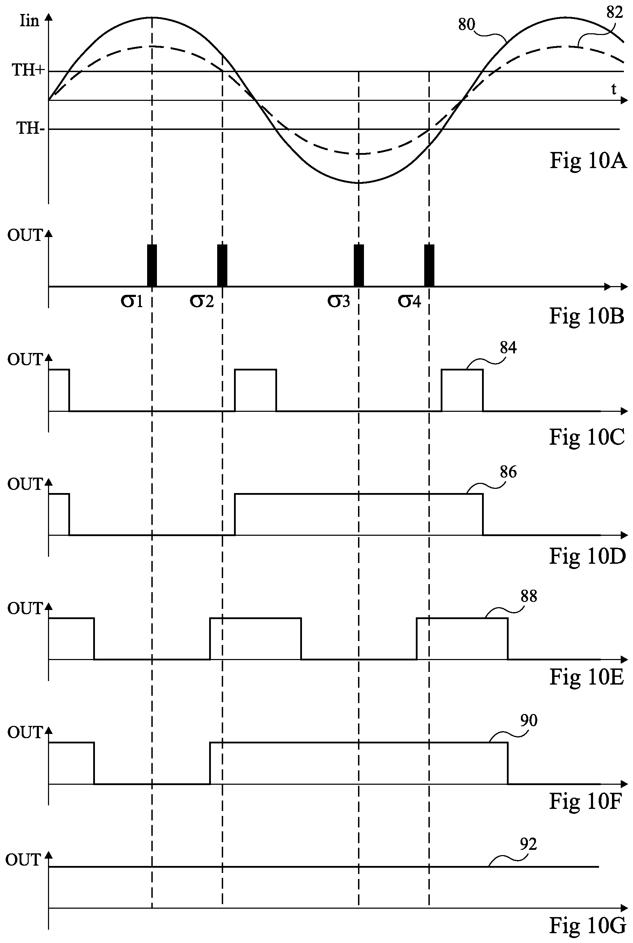

Les figures 10A à 10G sont des chronogrammes illustrant un procédé de surveillance de l'état d'une charge selon un autre mode de réalisation.

On considère un circuit similaire au circuit de la figure 1 comprenant, en série, une charge Q et un commutateur T commandé par un signal de commande CT. Le commutateur T peut être un triac. Une résistance R_{Q} est placée en parallèle avec la charge Q et un comparateur à fenêtre, qui mesure un courant Iin prélevé au point d'interconnexion entre la charge Q et le commutateur T, est placé en parallèle avec le commutateur T.

La figure 10A est un chronogramme illustrant l'allure du courant Iin dans deux cas où l'interrupteur T est ouvert et où l'état de la charge Q varie. La courbe 80 illustre le cas où la charge Q fonctionne correctement et la courbe 82 illustre le cas où la charge Q est défaillante ou déconnectée.

Le procédé selon un mode de réalisation consiste à détecter la valeur du signal sur la sortie OUT du comparateur à fenêtre à des instants choisis, ce qui permet de connaître l'état du commutateur T et de la charge Q.

La figure 10B est un chronogramme sur lequel sont illustrés de tels instants σ1, σ2, σ3 et σ4. Dans cet exemple, l'instant σ1 correspond au maximum de la tension d'alimentation alternative (Vac) et l'instant σ3 correspond au minimum de cette tension. L'instant σ2 est compris entre l'instant σ1 et la fin de l'alternance positive de la tension alternative et l'instant σ4 est compris entre l'instant σ3 et la fin de l'alternance négative de la tension alternative. Les instants σ2 et σ4 sont choisis de façon que le signal sur la sortie OUT soit, à ces instants, dans un état lorsque la charge Q fonctionne correctement et dans un autre état lorsque la charge Q est connectée et défaillante ou déconnectée.

Les chronogrammes des figures 10C à 10G illustrent l'allure du signal sur la sortie OUT dans plusieurs états du circuit. La figure 10C illustre l'allure 84 du signal sur la sortie OUT lorsque le triac T est ouvert et que la charge Q fonctionne correctement. La figure 10D illustre l'allure 86 du signal OUT lorsque le triac T est en mode diode et que la charge Q fonctionne correctement. La figure 10E illustre l'allure 88 du signal OUT lorsque le triac T est ouvert et que la charge Q présente une défaillance ou est déconnectée. La figure 10F illustre l'allure 90 du signal OUT lorsque le triac T est en mode diode et que la charge Q présente une défaillance ou est déconnectée. La figure 10G illustre l'allure 92 du signal OUT lorsque le triac est fermé.

On mémorise l'état du signal sur la sortie OUT aux instants σ1, σ2, σ3 et σ4 (état haut, 1, ou bas, 0). Ensuite, on compare, par mots d'états logiques, ces états à la table suivante qui lie les différents états possibles de la charge Q et du triac T avec les niveaux correspondants de la sortie OUT aux instants σ1, σ2, σ3 et σ4. Dans cette table, on prend en compte le signal de commande CT du commutateur T (niveau 1 si le commutateur est commandé en fermeture et niveau 0 si le commutateur est commandé en ouverture).

| CT | σ1 | σ2 | σ3 | σ4 | Triac | Charge |
|---|---|---|---|---|---|---|
| 0 | 0 | 0 | 0 | 0 | Fonctionne | Fonctionne |
| 0 | 0 | 0 | 1 | 1 | Mode diode | Fonctionne |
| 0 | 0 | 1 | 0 | 1 | Fonctionne | Défaillante |
| 0 | 0 | 1 | 1 | 1 | Mode diode | Défaillante |
| 0 | 1 | 1 | 1 | 1 | Défaillant/fermé | Etat non connu |
| 0 | 1 | 1 | 0 | 0 | Mode diode | Fonctionne |
| 0 | 1 | 1 | 0 | 1 | Mode diode | Défaillante |
| 1 | 0 | 0 | 0 | 0 | Défaillant/ouvert | Fonctionne |
| 1 | 0 | 0 | 1 | 1 | Défaillant/diode | Fonctionne |
| 1 | 0 | 1 | 0 | 1 | Défaillant/ouvert | Défaillante |
| 1 | 0 | 1 | 1 | 1 | Défaillant/diode | Défaillante |
| 1 | 1 | 1 | 1 | 1 | Fonctionne | Etat non connu |
| 1 | 1 | 1 | 0 | 0 | Défaillant/diode | Fonctionne |
| 1 | 1 | 1 | 0 | 1 | Défaillant/diode | Défaillante |

On obtient ainsi l'état du commutateur T et de la charge Q en fonction du signal de commande CT.

Ce procédé de détection peut également permettre de détecter l'état de tous les éléments d'un circuit tel que celui de la figure 1 comprenant en outre un commutateur SW. Pour cela, il suffit de fixer des instants supplémentaires pendant lesquels on détecte l'état du signal sur la sortie OUT. Dans le cas du circuit de la figure 1, il faut prévoir au moins 8 instants de détection adaptés pour obtenir l'état de tous les éléments du circuit (charge Q, commutateurs T et SW).

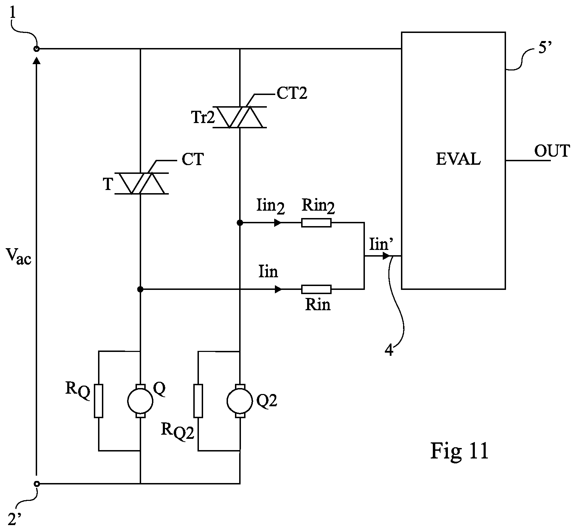

La figure 11 illustre un circuit de surveillance de l'état de deux charges en parallèle selon un autre mode de réalisation.

Ce circuit comprend deux branches en parallèle placées entre deux bornes 1 et 2' d'application d'une tension d'alimentation alternative Vac. La première branche comprend, en série, une charge Q et un triac T commandé par un signal de commande CT d'un programmateur (non représenté). Une résistance R_{Q}, de valeur supérieure à l'impédance de la charge Q, est placée en parallèle avec la charge Q. La seconde branche comprend une charge Q2 en série avec un triac Tr2 commandé par un signal de commande CT2 d'un programmateur (non représenté). Une résistance R_{Q2}, de valeur supérieure à l'impédance de la charge Q2, est placée en parallèle avec la charge Q2. Un comparateur à fenêtre 5' (EVAL), du même type que celui représenté en figures 2 et 4 (excepté que la résistance Rin est externe dans le cas du comparateur 5'), est placé entre la borne 1 et une borne 4. La borne 4 est connectée au point d'interconnexion entre le triac T et la charge Q par l'intermédiaire d'une résistance Rin de conversion tension-courant, le courant circulant dans cette résistance étant appelé Iin. La borne 4 est également connectée au point d'interconnexion du triac Tr2 et de la charge Q2 par l'intermédiaire d'une résistance Rin₂ de conversion tension-courant, le courant circulant dans cette résistance étant appelé Iin₂. Les résistances Rin et Rin₂ ont des valeurs élevées et ont pour rôle d'assurer la tenue en tension du comparateur à fenêtre 5' par rapport à la tension alternative d'entrée Vac. Le comparateur évalue la somme Iin' des courants Iin et Iin₂ et fournit une sortie OUT qui est, par exemple, à un niveau haut lorsque le courant Iin' est situé dans une fenêtre de courants et à un niveau bas autrement. Cette fenêtre de courants sera adaptée à la sélection désirée.

Ainsi, ce circuit fonctionne sensiblement de la même façon que le circuit représenté en figure 1. Les valeurs différentes des résistances Rin, Rin₂, R_{Q} et R_{Q2} permettent de décaler temporellement les instants de commutation du signal sur la sortie OUT lorsqu'il y a changement de l'état du circuit. Lorsque le triac T est ouvert et qu'un élément de la première branche est défaillant, le courant Iin varie, ce qui se répercute sur le courant Iin' et donc sur les instants de commutation du signal sur la sortie OUT. De la même façon, lorsque le triac Tr2 est ouvert et qu'un élément de la seconde branche est défaillant, le courant Iin₂ varie et les instants de commutation du signal sur la sortie OUT également.

En choisissant des seuils TH- et TH+ adaptés à ces différentes variations, on détecte, que ce soit par le procédé décrit en relation avec les figures 5 à 9 ou avec les figures 10A à 10G, l'état de chaque élément du circuit. Si on utilise le procédé de détection des figures 10A à 10G, il est nécessaire de définir suffisamment d'instants σ1, σ2, ..., on de détection de l'état du signal sur la sortie OUT pour distinguer les différents états du circuit.

A titre d'exemple non limitatif, on pourra choisir les valeurs des résistances suivantes : R_{Q} = R_{Q2} = 470 kΩ, Rin = 510 kΩ et Rin₂ = 240 kΩ.

Des modes de réalisation particuliers de la présente invention ont été décrits. Diverses variantes et modifications apparaîtront à l'homme de l'art. En particulier, on a présenté ici des procédés de surveillance d'un ou de plusieurs éléments d'un circuit constitué de branches comprenant une charge en série avec un ou deux commutateurs mais la présente invention s'applique également à la détection de l'état d'un ou de plusieurs éléments de branches comprenant plus de deux commutateurs ou plusieurs charges en série. Dans ce cas, des résistances ayant des valeurs différentes sont placées en parallèle avec les différents éléments pour en permettre la surveillance.

L'homme de l'art comprendra également que le procédé décrit en relation avec la figure 11 s'applique également à un circuit comprenant plus de deux branches en parallèle.

De plus, l'invention s'applique quel que soit le type de charge que l'on souhaite surveiller, pourvu que celle-ci ait, en fonctionnement normal, une impédance relativement faible par rapport à la résistance avec laquelle elle est en parallèle. A titre d'exemple, le procédé décrit ici pourra être utilisé dans des appareils électrodomestiques et analogues, par exemple un chauffe-eau instantané, un motocompresseur, un appareil de réfrigération, une sorbetière ou un appareil produisant de la glace, une pompe à chaleur électrique, un climatiseur, un déshumidificateur, par exemple pour satisfaire à la norme IEC/EN 60335-1.

## Revendications

1. Procédé de détection de l'état d'au moins un élément d'un circuit comprenant une ou plusieurs charges (Q), alimentées par une tension alternative (Vac) et en série avec au moins un premier commutateur (T), **caractérisé en ce que** l'état de l'élément est obtenu en analysant, à plusieurs instants (σ1, σ2, σ3, σ4) par période de la tension alternative, l'amplitude d'un courant (Iin) prélevé au point d'interconnexion entre la charge et le premier commutateur, l'analyse consistant à comparer, à chaque instant (σ1, σ2, σ3, σ4), l'amplitude du courant (Iin) à au moins un seuil de courant (TH- ; TH+), à former un mot d'états logiques à partir du résultat des comparaisons et à comparer ce mot d'états logiques à des mots stockés dans une table.

2. Procédé selon la revendication 1, dans lequel un premier instant (σ1) correspond au maximum de la tension alternative (Vac), un deuxième instant (σ3) correspond au minimum de la tension alternative, un troisième instant (σ2) est compris entre le premier instant et la fin de l'alternance positive de la tension alternative, et un quatrième instant (σ4) est compris entre le deuxième instant et la fin de l'alternance négative de la tension alternative.

3. Procédé selon la revendication 1 ou 2, dans lequel un premier seuil de courant (TH+) est défini lors de l'alternance positive de la tension alternative (Vac) et un second seuil de courant (TH-) est défini lors de l'alternance négative de la tension alternative.

4. Procédé selon l'une quelconque des revendications précédentes, permettant en outre de déterminer l'état d'un deuxième commutateur (SW) placé en série avec le premier commutateur (T) et la charge (Q) en analysant, à au moins huit instants par période de la tension alternative (Vac), l'amplitude du courant (Iin) prélevé au point d'interconnexion entre la charge et le premier commutateur.

5. Procédé selon l'une quelconque des revendications précédentes, permettant en outre de déterminer l'état d'au moins un élément d'au moins une seconde branche, parallèle à une première branche comprenant en série au moins la charge (Q) et au moins le premier commutateur (T), la seconde branche comprenant au moins une seconde charge (Q2) et au moins un troisième commutateur (Tr2), en analysant, à plusieurs instants par période de la tension alternative (Vac), l'amplitude d'un courant (Iin') égal à la somme du courant (Iin) prélevé au point d'interconnexion entre la première charge (Q) et le premier commutateur et d'un courant (Iin₂) prélevé au point d'interconnexion entre la seconde charge (Q2) et le troisième commutateur (Tr2).

6. Procédé selon l'une quelconque des revendications 1 à 5, appliqué à la surveillance d'un appareil électrodomestique conformément à la norme IEC/EN 60335-1.

7. Circuit de détection de l'état d'au moins un élément d'un circuit comprenant une ou plusieurs charges (Q) alimentées par une tension alternative (Vac) en série avec au moins un premier commutateur (T), **caractérisé en ce qu'**il comprend un moyen d'analyse de l'amplitude d'un courant (Iin), prélevé au point d'interconnexion entre la charge et le premier commutateur, à plusieurs instants (σ1, σ2, σ3, σ4) par période de la tension alternative, de comparaison, à chaque instant, de l'amplitude du courant (Iin) à au moins un seuil de courant (TH-; TH+), de formation d'un mot d'états logiques à partir du résultat des comparaisons, et de comparaison de ce mot d'états logiques à des mots stockés dans une table.

8. Circuit selon la revendication 7, comprenant en outre au moins un deuxième commutateur (SW) en série avec la charge (Q) et le premier commutateur (T) dont l'état peut être déterminé par le moyen d'analyse de l'amplitude du courant (Iin) prélevé au point d'interconnexion entre la charge et le premier commutateur, à au moins huit instants par période de la tension alternative (Vac).

9. Circuit selon la revendication 7 ou 8, comprenant une seconde branche en parallèle d'une première branche comprenant au moins la charge (Q) et au moins le premier commutateur (T), la seconde branche comprenant au moins une seconde charge (Q2) et un troisième commutateur (T2) dont les états peuvent être déterminés par le moyen d'analyse de l'amplitude d'un courant (Iin') égal à la somme du courant (Iin) prélevé au point d'interconnexion entre la première charge (Q) et le premier commutateur (T) et d'un courant (Iin₂) prélevé au point d'interconnexion entre la seconde charge (Q2) et le troisième commutateur (Tr2).

## Patentansprüche

1. Ein Verfahren zum Detektieren des Zustands von wenigstens einem Element einer Schaltung, die Folgendes aufweist eine oder mehrere Lasten (Q), die durch eine Wechselspannung (Vac) und in Reihe mit wenigstens einem ersten Schalter (T) mit Leistung versorgt werden, **dadurch gekennzeichnet, dass** der Zustand des Elements durch Analysieren erhalten wird, und zwar zu verschiedenen Zeitpunkten (σ1, σ2, σ3, σ4) in einer Periode der Wechselspannung, wobei die Amplitude eines Stroms (Iin) von dem Knotenpunkt der Last und des ersten Schalters abgetastet wird, wobei die Analyse folgendes beinhaltet Vergleichen zu jedem Zeitpunkt (σ1, σ2, σ3, σ4) der Amplitude des Stroms (Iin) mit wenigstens einem Stromschwellenwert (TH-; TH+), Bilden eines Wortes von logischen Zuständen aus dem Ergebnis des Vergleichs und Vergleichen dieses logischen Zustandswortes mit in einer Tabelle gespeicherten Wörtern.

2. Verfahren nach Anspruch 1, wobei ein erster Zeitpunkt (σ1) mit dem Maximum der Wechselspannung (Vac) korrespondiert, ein zweiter Zeitpunkt (σ3) mit dem Wechselspannungsminimum korrespondiert, ein dritter Zeitpunkt (σ2) zwischen dem ersten Zeitpunkt und dem Ende der positiven Halbwelle der Wechselspannung liegt, und ein vierter Zeitpunkt (σ4) zwischen dem zweiten Zeitpunkt und dem Ende der negativen Halbwelle der Wechselspannung liegt.

3. Verfahren nach Anspruch 1 oder 2, wobei ein erster Stromschwellenwert (TH+) während der positiven Halbwelle der Wechselspannung (Vac) definiert ist und ein zweiter Stromschwellenwert (TH-) während der negativen Halbwelle der Wechselspannung definiert ist.

4. Verfahren nach einem der vorhergehenden Ansprüche, das ferner das Bestimmen des Zustands eines zweiten Schalters (SW) ermöglicht, der in Reihe mit dem ersten Schalter (T) und der Last (Q) angeordnet ist durch Analysieren der Amplitude des Stroms (Iin), die von dem Knotenpunkt der Last und von dem ersten Schalter abgetastet wird, wenigstens acht Mal pro Periode der Wechselspannung (Vac).

5. Verfahren nach einem der vorhergehenden Ansprüche, das ferner das Bestimmen des Zustands von wenigstens einem Element eines wenigstens zweiten Zweiges ermöglicht, der parallel zu einem ersten Zweig ist, der in Reihe wenigstens die Last (Q) und wenigstens den ersten Schalter (T) aufweist, wobei der zweite Zweig wenigstens eine zweite Last (Q2) und wenigstens einen dritten Schalter (Tr2) aufweist durch Analysieren zu mehreren Zeitpunkten in einer Periode der Wechselspannung (Vac) der Amplitude eines Stroms (Iin'), der gleich ist zu der Summe des Stroms (Iin), der von dem Knotenpunkt der ersten Last (Q) und des ersten Schalters und von einem Strom (Iin₂), der von dem Knotenpunkt der zweiten Last (Q2) und des dritten Schalters (Tr2) abgetastet wird,.

6. Verfahren nach einem der Ansprüche 1 bis 5, angewandt auf das Beobachten eines elektrischen Haushaltsgerätes gemäß dem IEC/EN 60335-1 Standard.

7. Eine Schaltung zum Detektieren des Zustands von wenigstens einem Element einer Schaltung mit einem oder mehreren Lasten (Q), die durch eine Wechselspannung (Vac) in Reihe mit wenigstens einem ersten Schalter (T) mit Leistung versorgt wird, **dadurch gekennzeichnet, dass** sie Folgendes aufweist Mittel zum Analysieren der Amplitude eines Stroms (Iin), der von dem Knotenpunkt der Last und des ersten Schalters zu mehreren Zeitpunkten (σ1, σ2, σ3, σ4) in einer Periode der Wechselspannung abgetastet wird, zum Vergleichen der Amplitude des Stroms (Iin) mit wenigstens einem Stromschwellenwert (TH-; TH+) zu jedem Zeitpunkt zum Bilden eines Wortes von logischen Zuständen aus dem Ergebnis der Vergleiche und zum Vergleichen dieses logischen Zustandswortes mit in einer Tabelle gespeicherten Wörtern.

8. Schaltung nach Anspruch 7, die ferner Folgendes aufweist wenigstens einen zweiten Schalter (SW) in Reihe mit der Last (Q) und dem ersten Schalter (T), dessen Zustand bestimmt werden kann durch die Mittel zum Analysieren der Amplitude des Stroms (Iin), der von dem Knotenpunkt der Last und des ersten Schalters wenigstens acht Mal pro Periode des Wechselstroms (Vac) abgetastet wird.

9. Schaltung nach Anspruch 7 oder 8, die einen zweiten Zweig parallel mit einem ersten Zweig besitzt, der Folgendes aufweist wenigstens die Last (Q) und wenigstens den ersten Schalter (T), wobei der zweite Zweig wenigstens eine zweite Last (Q2) und einen dritten Schalter (T2) aufweist, wobei dessen Zustände bestimmt werden können durch die Mittel zum Analysieren der Amplitude eines Stroms (Iin'), der gleich der Summe des Stroms (Iin) ist, der von dem Knotenpunkt der ersten Last (Q) und dem ersten Schalter (T) und des Stroms (Iin₂), der von dem Knotenpunkt der zweiten Last (Q2) und dem dritten Schalter (Tr2) abgetastet wird.

## Claims

1. A method for detecting the state of at least one element of a circuit comprising one or several loads (Q), powered by an A.C. voltage (Vac) and in series with at least one first switch (T), **characterized in that** the state of the element is obtained by analyzing, at several times (σ1, σ2, σ3, σ4) in a period of the A.C. voltage, the amplitude of a current (Iin) sampled from the junction point of the load and of the first switch, the analysis consisting in comparing, at each time (σ1, o2, o3, o4), the amplitude of the current (Iin) with at least one current threshold (TH-; TH+), forming a word of logic states from the result of the comparisons, and comparing this logic state word with words stored in a table.

2. The method of claim 1, wherein a first time (σ1) corresponds to the maximum of the A.C. voltage (Vac), a second time (o3) corresponds to the A.C. voltage minimum, a third time (o2) is between the first time and the end of the positive halfwave of the A.C. voltage, and a fourth time (o4) is between the second time and the end of the negative halfwave of the A.C. voltage.

3. The method of claim 1 or 2, wherein a first current threshold (TH+) is defined during the positive halfwave of the A.C. voltage (Vac) and a second current threshold (TH-) is defined during the negative halfwave of the A.C. voltage.

4. The method of any of the preceding claims, further enabling determining the state of a second switch (SW) placed in series with the first switch (T) and the load (Q) by analyzing, at least eight times per period of the A.C. voltage (Vac), the amplitude of the current (Iin) sampled from the junction point of the load and of the first switch.

5. The method of any of the preceding claims, further enabling determining the state of at least one element of at least one second branch, parallel to a first branch comprising in series at least the load (Q) and at least the first switch (T), the second branch comprising at least a second load (Q2) and at least a third switch (Tr2), by analyzing, at several times in a period of the A.C. voltage (Vac), the amplitude of a current (Iin') equal to the sum of the current (Iin) sampled from the junction point of the first load (Q) and of the first switch and of a current (Iin₂) sampled from the junction point of the second load (Q2) and of the third switch (Tr2).

6. The method of any of claims 1 to 5, applied to monitor an electrodomestic device according to the IEC/EN 60335-1 standard.

7. A circuit for detecting the state of at least one element of a circuit having one or several loads (Q) powered by an A.C. voltage (Vac) in series with at least one first switch (T), **characterized in that** it comprises means for analyzing the amplitude of a current (Iin), sampled from the junction point of the load and of the first switch, at several times (σ1, σ2, σ3, σ4), in a period of the A.C. voltage, for comparing, at each time, the amplitude of the current (Iin) with at least one current threshold (TH-; TH+), for forming a word of logic states from the result of the comparisons, and for comparing this logic state word with words stored in a table.

8. The circuit of claim 7, further comprising at least one second switch (SW) in series with the load (Q) and the first switch (T), the state of which can be determined by the means for analyzing the amplitude of the current (Iin) sampled from the junction point of the load and of the first switch, at least eight times per period of the A.C. voltage (Vac).

9. The circuit of claim 7 or 8, having a second branch in parallel with a first branch comprising at least the load (Q) and at least the first switch (T), the second branch comprising at least a second load (Q2) and a third switch (T2), the states of which can be determined by the means for analyzing the amplitude of a current (Iin') equal to the sum of the current (Iin) sampled from the junction point of the first load (Q) and of the first switch (T) and of a current (Iin₂) sampled from the junction point of the second load (Q2) and of the third switch (Tr2) .
